# FASCICULE DE BREVET EUROPEEN

(11) **EP 0 795 953 B1**
(45) Date de publication et mention de la délivrance du brevet: **16.01.2002**
(21) Numéro de dépôt: 97104223.9
(22) Date de dépôt: 13.03.1997
(51) Int. Cl.: H03B 5/36

(54) **Dispositif électronique comprenant une base de temps intégrée**
Elektronische Vorrichtung mit integrierter Zeitbasis
Electronic device comprising an integrated time base

(30) Priorité: 15.03.1996 FR 9603292
(43) Date de publication de la demande: 17.09.1997
(73) Titulaire: Eta SA Fabriques d'Ebauches, 2540 Grenchen (CH)
(72) Inventeur: Jean, Hermann, 2006 Neuchâtel (CH)
(74) Mandataire: Balsters, Robert

(56) Documents cités:
- EP-A- 0 155 145
- FR-A- 2 383 073
- US-A- 4 456 850
- US-A- 4 640 756
- US-A- 5 075 641
- US-A- 5 166 646
- SENSORS AND ACTUATORS A, vol. A22, no. 1 / 03, 1 Mars 1990, pages 636-638, XP000358508 KRUMMENACHER P ET AL: "SMART TEMPERATURE SENSOR IN CMOS TECHNOLOGY"

## Description

La présente invention concerne un dispositif électronique comprenant, au moins, une base de temps complètement intégrée, et plus particulièrement un dispositif électronique intégrant dans un seul et même substrat une base de temps, comportant un oscillateur et un résonateur, associée à des circuits intégrés en technologie CMOS et pouvant être utilisé dans une pièce d'horlogerie.

La base de temps d'une pièce d'horlogerie comporte généralement un oscillateur comprenant un résonateur à quartz et un circuit d'entretien qui fait vibrer le résonateur afin de fournir une fréquence d'oscillation plus ou moins stable, une chaîne de division et éventuellement, un circuit d'ajustement de la fréquence qui modifie le rapport de division de la chaîne de division. Le circuit d'entretien, la chaîne de division ainsi que le circuit d'ajustement sont couramment réalisés en technologie CMOS et sont intégrés dans un seul substrat. Par contre, le résonateur à quartz est un composant externe qui doit être spécialement connecté au circuit intégré, impliquant ainsi une opération spécifique de montage et des coûts inhérents à cette opération. On conçoit donc aisément l'intérêt d'une base de temps complètement intégrable sur le même substrat que le circuit qui utilise cette base de temps.

Il a déjà été proposé de réaliser un oscillateur purement électronique utilisant une capacité alimentée à partir d'une référence de courant. Un exemple en a, par exemple, été donné par Robert A. Blauschild à la conférence ISSCC 1994 sous le titre "An Integrated Time Reference". Une telle solution, si elle est intégrable, ne permet cependant pas d'atteindre les conditions requises par les applications horlogères à savoir : une grande précision et une très faible consommation.

Le brevet américain US-A-4 890 370 décrit un procédé de structuration d'une plaquette de silicium en vue de la fabrication d'un résonateur intégré dans cette plaquette. Toutefois, ce document ne mentionne, sans le décrire, qu'un résonateur mince à haute fréquence (plusieurs dizaines de MHz) vibrant selon un mode d'épaisseur. Un tel résonateur ne saurait convenir pour des applications horlogères.

Un but de la présente invention est d'apporter une solution aux problèmes mentionnés de l'art antérieur en fournissant un dispositif électronique comprenant au moins une base de temps avec un résonateur intégré.

Un autre but de la présente invention est de présenter un tel dispositif qui est peu coûteux et facile à réaliser.

Un autre but de l'invention est un dispositif comprenant, dans un même substrat, une base de temps, son résonateur intégré et des moyens d'ajustement de la fréquence en fonction de la température.

L'invention a donc pour objet un dispositif électronique intégré comprenant dans un même substrat en silicium un résonateur, un circuit d'entretien, et une chaîne de division de fréquence, ledit circuit d'entretien, ainsi que ladite chaîne de division étant fabriqués en technologie CMOS, ledit dispositif étant caractérisé en ce que ledit résonateur est un résonateur intégré constitué d'un corps découpé dans une partie délimitée superficielle amincie dudit substrat, d'une couche mince de matériau piézo-électrique déposée sur au moins une partie dudit corps, et d'une couche mince métallique déposée sur ladite couche piézo-électrique pour former une électrode.

De préférence, le résonateur intégré est constitué d'une partie centrale allongée associée à deux parties extrêmes pour former ensemble un barreau chargé par deux masses terminales. La couche piézo-électrique est déposée sur la partie centrale. Le résonateur est fixé au substrat par l'intermédiaire d'un bras connecté au centre du barreau. Il est prévu pour vibrer selon un mode d'allongement, ce qui permet d'obtenir un couplage piézo-électrique élevé.

La structure particulière du résonateur permet un procédé de fabrication en post-traitement, c'est-à-dire que le procédé de fabrication du résonateur est compatible avec le procédé de fabrication CMOS du dispositif électronique selon l'invention et ne nécessite que quelques étapes supplémentaires. La forme spécifique du résonateur et le mode de vibration choisi permettent, en outre, d'obtenir un facteur de qualité élevé et ses dimensions peuvent être adaptées pour obtenir la fréquence désirée avec une consommation et un encombrement réduits.

Avantageusement, le dispositif selon l'invention permet de fournir une fréquence très stable en incorporant un circuit de mesure de température intégré pour compenser les variations de la fréquence du résonateur en fonction de la température.

On va décrire ci-après, à titre d'exemple uniquement, un mode de réalisation de l'objet de l'invention en se référant aux dessins annexés, dans lesquels :
- la figure 1 représente schématiquement un dispositif électronique intégré selon l'invention,
- la figure 2 montre schématiquement la forme d'un résonateur intégré destiné à être utilisé dans le dispositif selon la figure 1, et
- la figure 2a est une vue schématique en coupe selon la ligne IIa-IIa de la figure 2, montrant la structure du résonateur intégré.

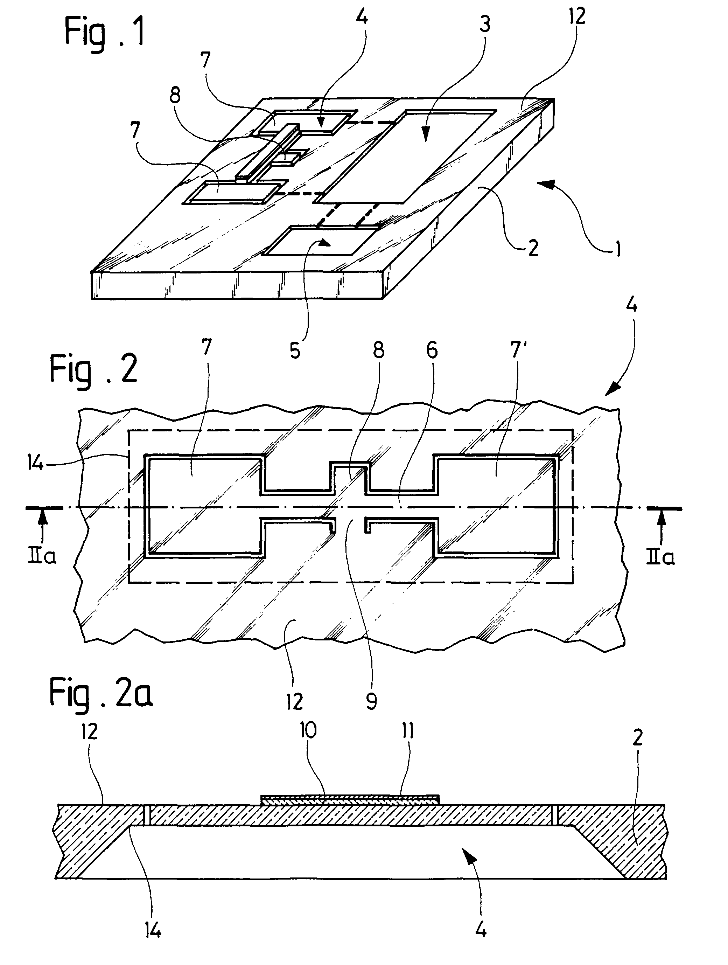

La figure 1 représente schématiquement un dispositif électronique intégré 1 selon l'invention. Le dispositif 1 comprend un substrat 2 de silicium monocristallin. Dans ce substrat 2 est formé un circuit intégré 3 comprenant un circuit d'entretien et une chaîne de division d'une base de temps. Ce circuit intégré 3 est en fait constitué par les différents composants d'une base de temps sans résonateur. Il s'agit d'un circuit intégré fabriqué dans le substrat par un procédé de fabrication CMOS pour créer les différents composants de ce circuit intégré 3 dans une zone superficielle 12 du substrat 2. Ceci peut être réalisé d'une façon connue de l'homme de métier, et ne sera pas décrit plus en détail ici. La base de temps 3 comporte un circuit d'entretien et est agencée pour fournir une fréquence de sortie destinée à alimenter, par exemple, un circuit de commande de l'affichage d'une pièce d'horlogerie (non représentée).

A cet effet, le circuit intégré 3 comprend en outre, d'une façon connue, une chaîne de division pour diviser la fréquence fournie par l'oscillateur. Avantageusement, un circuit d'ajustement est prévu, par exemple un circuit d'inhibition, pour une mise à la fréquence précise et pour une compensation en température. Un tel circuit est également connu de l'homme de métier, et ne sera pas décrit en détail ci-après. Le circuit d'entretien est associé à un résonateur intégré 4 fabriqué dans le même substrat 2 que le circuit intégré 3.

La figure 2 montre schématiquement la forme du résonateur intégré 4. Le résonateur 4 est formé dans une partie amincie du substrat 2. Cette partie amincie peut être obtenue par attaque de la plaquette dans une zone délimitée 14. L'épaisseur résiduelle de cette partie amincie sera de l'ordre de 50 micromètres; cette valeur n'étant, toutefois, pas critique. De préférence, le résonateur 4 est constitué d'une partie centrale allongée en forme de barreau 6 qui est chargée à chacune de ses extrémités par une masse terminale 7, 7'. Ces masses 7, 7' sont destinées à atténuer la fréquence du résonateur 4. Le barreau, ou la partie centrale 6, est connecté au substrat 2 au moyen d'une zone de découplage 9. Il est encore prévu une zone 8 qui n'a pas d'autre fonction que d'assurer la symétrie globale du résonateur.

En se référant à la figure 2a, on voit que le résonateur 4 comprend une couche mince 10 de matériau piézo-électrique déposée uniquement sur la partie centrale 6 du résonateur 4. Une couche mince métallique 11 est déposée sur la couche piézo-électrique 10 pour constituer une électrode, la deuxième électrode étant constituée par le corps en silicium dopé du résonateur. Seule la surface totale du dépôt de la couche piézo-électrique détermine le couplage piézo-électrique, ce qui fait que la forme du dépôt n'est pas critique.

Le choix d'un matériau parmi les différents matériaux piézo-électriques détermine entre autres la consommation du résonateur. Le matériau doit, en outre, être stable pour ne pas trop influencer la fréquence de l'oscillateur. De plus, ce matériau doit pouvoir être déposé sur le résonateur d'une manière compatible avec les procédés de fabrication CMOS classiques.

Il a été constaté expérimentalement, que l'utilisation du nitrure d'aluminium AlN en tant que matériau piézo-électrique convient particulièrement bien. En effet, bien qu'il s'agisse d'un matériau semiconducteur, la résistivité à la température ambiante est élevée, et par conséquent, la stabilité aussi. De plus, ce matériau, qui est compatible avec les matériaux classiques de la micro-électronique, permet un dépôt par un procédé de pulvérisation cathodique (connu sous le terme anglais de "sputtering") à des températures compatibles avec les procédés de fabrication CMOS prévus pour réaliser le dispositif 1 selon l'invention.

La géométrie du résonateur qui vient d'être décrite permet d'obtenir un très bon découplage par rapport au substrat 2, et un facteur de qualité Q élevé. On rappellera que le facteur de qualité est égal à 2π fois le rapport de l'énergie interne du résonateur (énergie cinétique + énergie potentielle) à l'énergie perdue par ce dernier par cycle d'oscillation. Avantageusement, ce découplage peut encore être optimisé par un léger décalage entre l'axe de symétrie des masses terminales 7, 7' et la partie centrale 6 qui les relie. Un exemple des dimensions du résonateur 4 est le suivant : une longueur qui est de l'ordre de 2,1 mm, une largeur de l'ordre de 0,7 mm et une épaisseur de plusieurs dizaines de micromètres (10⁻⁶ m).

Le fonctionnement du résonateur intégré 4 est le suivant. En appliquant une tension alternative entre la couche métallique 11 et le substrat 2, la couche piézo-électrique 10 entraînera la vibration de la partie centrale 6 du résonateur 4.

Pour le résonateur de l'invention une fréquence de 2²⁰ Hz (≈ 1,05 MHz) a été choisie. La couche piézo-électrique 10 est excitée d'une manière telle que le résonateur 4 vibre en mode fondamental d'allongement dans le plan. La partie centrale 6 s'allonge dans son plan alternativement vers la partie extrême 7 et vers la partie extrême 7'.

Par ailleurs, il a été observé expérimentalement que le coefficient thermique d'un tel résonateur en silicium est de l'ordre de -30 ppm/°C. Il est alors hautement souhaitable d'incorporer, dans le même substrat 2, un circuit de mesure de la température dont le signal de sortie peut être utilisé pour compenser cette variation en contrôlant le circuit d'ajustement de fréquence de la base de temps.

A cet effet, le dispositif électronique 1 selon l'invention comprend avantageusement en outre un circuit de mesure de température intégré 5. Le circuit de mesure 5 peut être constitué de transistors bipolaires verticaux agencés d'une manière à compenser les variations de la fréquence du résonateur 4 en fonction de la température. Un exemple d'un tel circuit de mesure est décrit dans l'article "Smart Temperature Sensor in CMOS Technology" de MM. P. Krumenacher et H. Oguey, paru dans "Sensors and Actuators", A21-A23 (1990), pp 636 - 638.

Un exemple d'un procédé de fabrication du résonateur 4 est donné ci-après. La face arrière du substrat 2 peut être attaquée chimiquement pour définir une partie délimitée 14 d'épaisseur réduite. Ensuite, un gravage de la face avant peut être effectué pour définir la géométrie du résonateur 4. Ensuite, un seul masque supplémentaire suffit pour déposer et métalliser la couche piézo-électrique 10.

Grâce à sa structure particulière ainsi qu'à sa forme spécifique, le résonateur peut facilement être incorporé dans une base de temps comprenant un circuit intégré 3 pour former une base de temps intégrée, et ce résonateur est compatible sur le plan de la consommation avec le circuit intégré 3 en technologie CMOS. De plus, cette base de temps intégrée comprenant un tel résonateur est plus stable et plus précise que les bases de temps intégrées connues.

Bien qu'un mode préféré de réalisation du dispositif selon l'invention soit décrit ci-dessus, l'invention n'est pas limitée à ce mode de réalisation spécifique, lequel est donné uniquement à titre d'exemple non limitatif de l'invention.

## Revendications

1. Dispositif électronique intégré (1) comprenant un substrat (2) en silicium monocristallin, et comportant un circuit intégré (3) comprenant un oscillateur comportant un résonateur, un circuit d'entretien pour faire vibrer le résonateur, et une chaîne de division de fréquence, ledit circuit d'entretien ainsi que ladite chaîne de division étant réalisés sous forme de circuits CMOS, ledit dispositif étant **caractérisé en ce que** ledit résonateur est un résonateur intégré (4) constitué d'un corps découpé dans une partie délimitée superficielle amincie (14) dudit substrat (2), d'une couche mince de matériau piézo-électrique (10) déposée sur au moins une partie (6) dudit corps, et d'une couche mince métallique (11) déposée sur ladite couche piézo-électrique (10) pour former une électrode.

2. Dispositif électronique selon la revendication 1, **caractérisé en ce que** le résonateur intégré (4) comprend une partie centrale allongée (6) associée à deux parties extrêmes (7, 7') formant ensemble un barreau chargé à chacune de ses extrémités par une masse terminale, et constituant ainsi le résonateur intégré (4), et **en ce que** ladite couche piézo-électrique (10) est déposée uniquement sur ladite partie centrale (6).

3. Dispositif électronique selon la revendication 1 ou 2, **caractérisé en ce que** ladite couche mince de matériau piézo-électrique (10) est constituée par du nitrure d'aluminium (AlN).

4. Dispositif électronique selon l'une quelconque des revendications précédentes, **caractérisé en ce que** le dispositif (1) comprend en outre un circuit de mesure de température intégré (5) destiné à compenser les variations de la fréquence dudit résonateur (4) en fonction de la température.

## Patentansprüche

1. Integrierte elektronische Vorrichtung (1), die ein Substrat (2) aus monokristallinem Silicium enthält und eine integrierte Schaltung (3) umfaßt, die einen Oszillator enthält, der einen Resonator, eine Unterhaltungsschaltung, die den Resonator schwingen läßt, sowie eine Frequenzteilerkette umfaßt, wobei die Unterhaltungsschaltung und die Teilerkette in Form von CMOS-Schaltungen verwirklicht sind, wobei die Vorrichtung **dadurch gekennzeichnet ist, daß** der Resonator ein integrierter Resonator (4) ist, der aus einem Körper, der aus einem abgeschrägten, begrenzten Oberflächenabschnitt (14) des Substrats (2) ausgeschnitten ist, aus einer dünnen Schicht aus piezoelektrischem Material (10), die wenigstens auf einem Teil (6) des Körpers aufgebracht ist, und aus einer dünnen Metallschicht (11), die auf der piezoelektrischen Schicht (10) aufgebracht ist, um eine Elektrode zu bilden, gebildet ist.

2. Elektronische Vorrichtung nach Anspruch 1, **dadurch gekennzeichnet, daß** der integrierte Resonator (4) einen langgestreckten Mittelabschnitt (6) umfaßt, dem zwei Endabschnitte (7, 7') zugeordnet sind und die zusammen einen Stab bilden, der an jedem seiner Enden mit einer Abschlußmasse belastet ist und dadurch den integrierten Resonator (4) bildet, und daß die piezoelektrische Schicht (10) ausschließlich auf den mittigen Abschnitt (6) aufgebracht ist.

3. Elektronische Vorrichtung nach Anspruch 1 oder 2, **dadurch gekennzeichnet, daß** die Dünnschicht aus piezoelektrischem Material (10) aus Aluminiumnitrid (AlN) gebildet ist.

4. Elektronische Vorrichtung nach einem der vorhergehenden Ansprüche, **dadurch gekennzeichnet, daß** die Vorrichtung (1) außerdem eine integrierte Temperaturmeßschaltung (5) umfaßt, die dazu bestimmt ist, die temperaturabhängigen Schwankungen der Frequenz des Resonators (4) zu kompensieren.

## Claims

1. Integrated electronic device (1) including a monocrystalline silicon substrate (2), and comprising an integrated circuit (3) including an oscillator comprising a resonator, a maintenance circuit to cause the resonator to vibrate, and a frequency division chain, said maintenance circuit as well as said division chain being manufactured as CMOS circuits, said device being **characterized in that** said resonator is an integrated resonator (4) formed of a body cut out in a delimited surface part (14) having a reduced thickness of said substrate (2), of a thin layer of piezoelectric material (10) deposited on at least a part (6) of said body, and of a thin metallic layer (11) deposited on said piezoelectric layer (10) so as to form an electrode.

2. Electronic device according to claim 1, **characterized in that** the integrated resonator (4) comprises a central elongated part (6) associated to two end parts (7, 7') forming together a bar which is loaded at each of its extremities by a terminating mass, and thus forming the integrated resonator (4), and **in that** said piezoelectric layer (10) is deposited only on said central part (6).

3. Electronic device according to claim 1 or 2, **characterized in that** said thin layer of piezoelectric material (10) is made of aluminium nitride (AlN).

4. Electronic device according to any one of the preceding claims, **characterized in that** the device (1) further comprises an integrated temperature measuring circuit (5) intended to compensate for the variation of the frequency of said resonator (4) as a function of the temperature.
